# EUROPEAN PATENT SPECIFICATION

(11) **EP 2 546 871 B1**
(45) Date of publication and mention of the grant of the patent: **05.12.2018**
(21) Application number: 10847346.3
(22) Date of filing: 12.03.2010
(51) Int. Cl.: H01L 23/373, H01L 23/433

(54) **METHOD FOR PRODUCING A HEAT DISSIPATING STRUCTURE**
VERFAHREN ZUR HERSTELLUNG EINER WÄRMEABLEITENDEN STRUKTUR
PROCÉDÉ DE FABRICATION D'UNE STRUCTURE DE DISSIPATION DE CHALEUR

(43) Date of publication of application: 16.01.2013
(73) Proprietor: Fujitsu Limited, Kawasaki-shi, Kanagawa 211-8588 (JP)
(72) Inventor: IWAI, Taisuke, Kawasaki-shi Kanagawa 211-8588 (JP); KONDO, Daiyu, Kawasaki-shi Kanagawa 211-8588 (JP); YAMAGUCHI, Yoshitaka, Kawasaki-shi Kanagawa 211-8588 (JP); HIROSE, Shinichi, Kawasaki-shi Kanagawa 211-8588 (JP); SAKITA, Yukie, Kawasaki-shi Kanagawa 211-8588 (JP); YAGISHITA, Yohei, Kawasaki-shi Kanagawa 211-8588 (JP); NORIMATSU, Masaaki, Kawasaki-shi Kanagawa 211-8588 (JP)
(74) Representative: Hoffmann Eitle
(86) International application number: PCT/JP2010/001775
(87) International publication number: WO 2011/111112

(56) References cited:
- EP-A2- 2 104 141
- EP-A2- 2 187 440
- JP-A- 2006 295 120
- JP-A- 2009 260 238
- US-A1- 2004 042 178
- US-A1- 2006 234 056
- US-A1- 2009 195 989

## Description

### FIELD

The present invention relates to a heat dissipating structure including a heat source and a heat dissipating part, and manufacture thereof.

### BACKGROUND

Electronic devices including central processing units (CPUs) used in servers and personal computers are provided with a heat spreader or a heat sink of a highly heat conductive material such as copper that is located immediately above a heat-generating semiconductor chip so that heat generated or released from the semiconductor element is dissipated efficiently.

Such a semiconductor chip and a heat spreader have surface roughness of submicron order. Even when they are directly abutted, they cannot form a sufficiently large contact area, and the contact interface will act as a large thermal resistance, which makes effective heat dissipation difficult. To reduce the thermal resistance at the contact, a thermal interface material is commonly disposed between a heat source and a heat spreader.

It is required for such a thermal interface material, in addition to having a high heat conductivity, to be adaptive to the fine surface roughness of a heat source and a heat spreader to ensure a large contact area. Materials commonly used at present include silicone grease, phase change material (PCM), which is a grease with better characteristics than silicone grease, and indium.

Silicone grease and PCM can create good contact with a fine-roughness surface, but their heat conductivity is in the range of about 1 to 5 W/mK. If these materials are to be used, the film thickness has to be decreased to achieve effective heat dissipation. A heat source and a heat spreader generally differ in thermal expansion coefficient, and a relative positional shift will occur as they undergo thermal expansion. The thermal interface material has to absorb this relative positional shift, placing a limit on the minimum thickness.

Indium has a heat conductivity (about 80W/mK) higher than that of PCM, and can be easily deformed or molten to create good contact. Indium is a rare metal, and the cost of indium is rising rapidly due to largely increasing demands. In addition, its heat conductivity cannot be said to be sufficiently high.

In recent years, attention has been focused on carbon nanotubes (CNTs) as a new electric and thermal conductor. Carbon nanotubes (CNTs) have a long tube-like structure formed of a graphene sheet in which carbon atoms are regularly arranged, and they are categorized into single-walled nanotubes (SWNTs), which are formed of a single wall, and multi-walled nanotubes (MWNTs), which are formed of a plurality of walls. Their diameter ranges from a minimum of 0.4 nm to a maximum of about 4 nm for single-walled ones, and they can be increased as large as several tens of nanometers for multi-layered ones. Their length can be controlled, for instance, in a wide range of 5 µm to 500 µm, by setting up appropriate growth conditions including growth time.

CNTs have very high electric conductivity and very high heat conductivity in their axial (longitudinal axis) direction. The heat conductivity in the axal direction of CNTs can be, for instance, as high as about 1,500 W/mK. CNTs have a thin cylindrical shape with high flexibility. They also have high refractoriness (heat resisting property). A wide range of studies have been carried out aiming to develop applications of CNTs as electric or thermal conductors. To produce carbon nanotubes for use as thermal interface, it is preferable to increase the density and control the orientation of CNTs so as to improve the heat dissipation characteristics.

Japanese Unexamined Patent Publication (Kokai) No. 2006-108377 (Japanese Patent No. 4167212) proposes to prepare a concave portion on one of two wiring layers opposed to each other, form a catalyst layer on the surface of the concave portion, and grow CNTs from the catalyst layer, thereby achieving an increased number density of CNTs and an increased electric conductivity as compared to CNTs grown on a flat plane, and also proposes to prepare many concave portions on a heat sink surface to be located opposite to a semiconductor chip, form a catalyst layer on the surface of each concave portion, and grow CNTs from the catalyst layer thereby achieving a bundle of CNTs with an increased number density, followed by connecting the bundle of CNTs to the semiconductor chip via a thermally conductive adhesion layer made of such material as Au and Sn.

In recent semiconductor integrated circuit devices, integration has been advancing. Increase in electric current density tends to cause increased heat generation and increased thermal expansion. When a semiconductor integrated circuit device is connected to a circuit substrate in fixed manner, difference in thermal expansion causes stress, which may lead to destruction of the device. If a semiconductor integrated circuit device is connected to a heat dissipating part via flexible CNTs, the stress attributable to difference in thermal expansion will be able to be largely reduced.

The growth temperature of CNT is commonly at 600°C or above in general (common) chemical vapor deposition (CVD). Many semiconductor devices and electronic parts cannot dure or resist heat history of 600°C or above. Method for growing CNTs at desired locations may impose limitations on the processes depending on the object. Accordingly, it is often difficult to grow CNTs directly at desired positions of a semiconductor device or electronic part.

Japanese Unexamined Patent Publication (Kokai) No. 2006-147801 proposes to grow a high density CNT assembly (sheet) on a substrate via a metal catalyst layer, coat a resin layer on a heat source such as a semiconductor element, bring the CNT assembly immerse into this resin layer, allow the resin to penetrate into spaces between CNTs, cure the resin, and thereafter remove the substrate, thereby leaving a sheet formed of CNTs bonded by a resin layer on a heat source.

The degree of freedom of a process can be increased if a high heat-conductivity component comprising oriented CNT assembly can be prepared separately. In this case, CNTs can be grown on a separate heat resisting substrate, followed by transferring the CNTs to a desired position on a semiconductor device or an electronic part to form a connection component. A CNT sheet comprising assembly of many carbon nanotubes (CNTs) oriented in the thickness direction and bound by resin material will give self-supporting ability to the CNT assembly and accordingly allow the CNT assembly to be handled easily. It is preferable that the resin material fills gaps between CNTs and can form face-to-face contact with a heat source and a heat dissipating part when disposed between the heat source and the heat dissipating part.

Published Japanese Translation of PCT International Publication JP 2007-506642 (WO2005/031864) proposes to mix CNTs with clay formed of aggregates of small plate-like particles, apply a shear force to orient the CNTs in a pull-out direction, and divide into pads after the pull-out procedure to form a thermal interface material having high heat conductivity in the thickness direction, and also proposes to mix CNTs with liquid crystal resin, spread the mixture into a layer, and align the CNTs in the thickness direction by applying an electric field, magnetic field, etc., thereby forming thermal interface material having high heat conductivity in the thickness direction.

Japanese Unexamined Patent Publication (Kokai) No. 2006-290736 proposes to grow high-density CNT assembly on a growth substrate via a metal catalyst, form a protective layer to cover exposed ends of the CNT assembly, remove the substrate, form a protective layer to cover the other exposed ends of the CNT assembly, inject a polymer solution among CNTs in the assembly, which has both ends covered by protective layers, solidify it to produce a substrate, remove the protective layers, form a phase change material layer, embedding the exposed ends of the CNTs, apply pressure and heat to melt the phase change material, bend the ends of the CNTs, and then cool and solidify the phase change material layer. The polymer solution to be used is, for instance, silicone rubber such as Sylgard 160 available from Dow Corning. The phase change material may comprise paraffin and may be softened and liquefied at the phase change temperature, for instance, 20°C to 90°C.

US 2009/0195989 A1 refers to a heat sink component for a semiconductor package including a thermal interface member with a thermally conductive material, and a heat sink member having a surface thereof that includes at least one projecting portion having a pointed shape or edge shape, a tip of which digs into the thermally conductive material.
US 2006/0234056 A1 refers to a thermal interface material including a matrix and a plurality of carbon nanotubes.

US 2004/0042178 A1 discloses a heat spreader for cooling an electronic component. The heat spreader includes a thermal interface material disposed in a cavity in the body of the heat spreader. The thermal interface material is at least partially enclosed in the cavity by a surface of the electronic component or a heat sink.
EP 2 104 141 A2 relates to a sheet structure and a method of manufacturing the sheet structure.
EP 2 187 440 A2 refers to a heat radiation material, an electronic device and a method of manufacturing the electronic device.

### SUMMARY

An object of the present invention is to provide a heat dissipating structure or an electronic instrument that has high heat dissipation efficiency and has a novel structure.

The present invention provides a method for manufacturing a heat dissipating structure comprising the features of claim 1.

### BRIEF DESCRIPTION OF DRAWINGS

Figs. 1A-1E are cross sections illustrating the processes for manufacturing CNT sheet according to an embodiment, and Figs. 1BX and 1F are cross sections illustrating the manufacturing process according to a first modification, Fig. 1BY is a schematic diagram illustrating a metal-covered end of a CNT, and Figs. 1BZ and 1G are cross sections illustrating the manufacturing process according to a second modification.
Figs. 2A-2D are cross sections illustrating the processes for manufacturing a heat dissipating structures adopted in a preliminary experiment and microscope photographs of a cracked sample.
Figs. 3A-3D are cross sections illustrating the processes for manufacturing a heat dissipating structure according to embodiment 1.
Figs. 4A-4D are cross sections illustrating the processes for manufacturing a heat dissipating structure according to embodiment 2.
Figs. 5A-5D are cross sections illustrating the processes for manufacturing a heat dissipating structure according to embodiment 3.
Figs. 6A-6F are perspective views illustrating a heat dissipating part or a heat source provided with a concave portion for restricting the CNT assembly.
Figs. 7A and 7B are side views illustrating other constitutions of the CNT sheet.
Figs. 8A-8C are schematic cross sections illustrating examples of specific applications.

### DESCRIPTION OF EMBODIMENTS

The present inventors have examined possibility of binding oriented CNTs with thermoplastic material into a sheet-like assembly. If the binding material for binding CNTs into a sheet shape is thermoplastic, the contact area of the sheet with the heat source and the heat dissipating part can be maximized as large as possible by heating the binding material to soften or melt it, to let the sheet itself in highly deformable state, while giving each CNT freedom of deformation, etc. If the ends of CNTs are brought into direct contact with the heat source and the heat dissipating part at the surfaces of the sheet and subsequently cooled, it will be possible to fix and maintain the contacting state of the CNT assembly. Processes for producing such a carbon nanotube sheet will be described below.

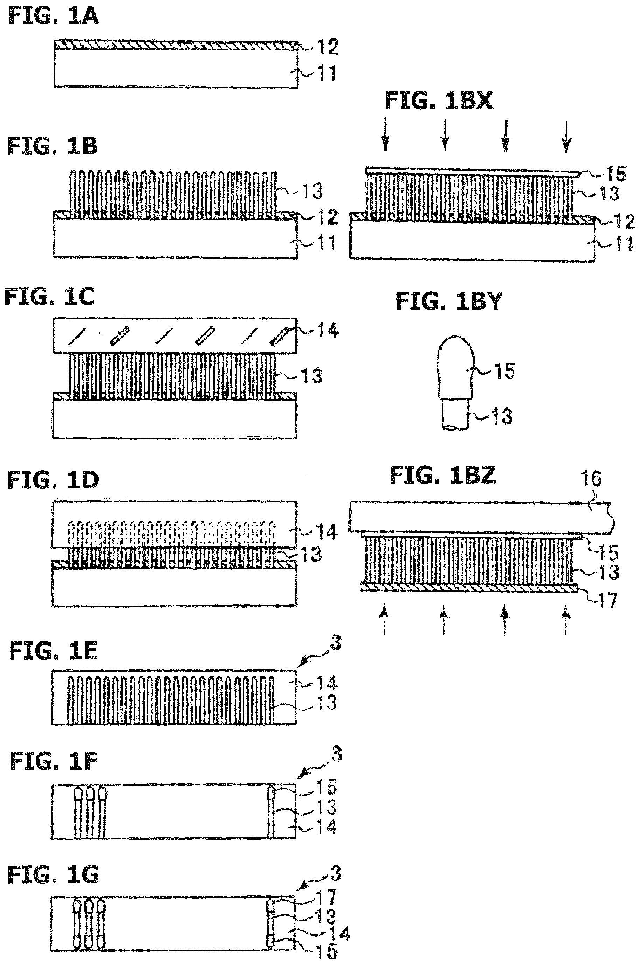

As illustrated in Fig. 1A, a growth substrate 11 to be used for forming carbon nanotubes is prepared. As the growth substrate 11, a semiconductor substrate such as a silicon substrate, an alumina (sapphire) substrate, a MgO substrate, a glass substrate, a metal substrate, etc. may be used. A thin film may be formed on such a substrate. An example is a silicon substrate formed with a silicon oxide film with a thickness of about 300 nm.

The growth substrate 11 will be removed after the formation of carbon nanotubes. To meet this aim, it is preferable that the growth substrate 11 does not change its property at the carbon nanotube formation temperature and that at least the surface in contact with carbon nanotubes is of a material that can be easily peeled off or removed from the carbon nanotubes, or of a material that can be etched selectively against the carbon nanotube.
For instance, Fe (iron) is deposited by sputtering to a thickness of 2.5 nm over the surface of a growth substrate 11 to form a catalyst metal film 12 of Fe. The catalyst metal may be Co (cobalt), Ni (nickel), Au (gold), Ag (silver), Pt (platinum), or an alloy containing at least one material thereof, instead of Fe. Instead of a metal film, the catalyst may be in the form of fine metal particles with controlled size prepared by using differential mobility analyzer (DMA) etc. The same metal species as for thin films may be used in this case.

An underlying film for the catalyst metal may be formed of Mo (molybdenum), Ti (titanium), Hf (hafnium), Zr (zirconium), Nb (niobium), V (vanadium), TaN (tantalum nitride), TiSiₓ (titanium silicide), Al (aluminum), Al₂O₃ (aluminum oxide), TiOₓ (titanium oxide), Ta (tantalum), W (tungsten or wolfram), Cu (copper), Au (gold), Pt (platinum), Pd (palladium), TiN (titanium nitride), or an alloy containing at least one of these materials. For instance, a laminated structure of Fe (2.5 nm)/AI (10 nm) or a laminated structure of Co (2.6 nm)/TiN (5 nm) may be adopted. When using fine metal particles, they may be in the form of, for instance, a laminated structure such as Co (average diameter 3.8 nm)/TiN (5 nm thick).

As illustrated in Fig. 1B, for instance, hot filament CVD is carried out to grow carbon nanotubes (CNTs) 13 on a growth substrate 11 using a catalyst metal film 12 as catalyst. Growth conditions for the carbon nanotube 13 may be, for instance, as follows: acetylene-argon mixture gas (partial pressure ratio 1:9) is used as source gas and a total gas pressure in a film formation chamber is 1 kPa, hot filament temperature is at 1,000°C, and a growth time is 20 minutes. These conditions will grow multi-layered carbon nanotubes of 3 to 6 layers (average of about 4 layers) with a diameter of 4 to 8 nm (average 6 nm) and a length of 80 µm (growth rate 4 µm/min).

Here, other film formation methods such as thermal CVD and remote plasma CVD may be used to grow a carbon nanotube 13. The carbon nanotubes to be grown may also be in the form of a monolayer carbon nanotubes. The source material for carbon may be a hydrocarbon such as methane and ethylene, or an alcohol such as ethanol and methanol, instead of acetylene.

A large number of carbon nanotubes 13 oriented perpendicularly to the substrate 11 are formed on the growth substrate 11, in this way. Carbon nanotubes have a property or habit that they will grow perpendicularly to the substrate when the number density is above a certain limit. The in-plane number desnsity of the carbon nanotubes 13 grown under the above growth conditions was about 1×10¹¹/cm².

As illustrated in Fig. 1C, a filler layer is made by potting using hot-melt resin, which is a thermoplastic resin, which will fill the spaces among carbon nanotubes 13. For instance, hot-melt resin processed into a sheet with a thickness of 100 µm may be used, and the hot-melt resin sheet 14 is put on carbon nanotubes 13. An example of such hot-melt resin is a Micromelt 6239 hot-melt filler (melting temperature 135°C to 145°C, molten state viscosity 5.5 Pa-s to 8.5 Pa-s at 225°C) available from Henkel Japan Ltd.

As illustrated in Fig. 1D, the resin 14 fills the spaces among the carbon nanotubes 13 and gaps among the bundles, by heating the resin to melt into a liquid state. A hot-melt resin layer with a thickness of 100 µm will completely embed CNTs with a length of 80 µm, when it is molten. Fig. 1E depicts a state in which resin has reached the growth substrate after impregnating CNTs. It is also possible to so control the processing time that impregnation stops halfway through (processing is terminated before the resin reaches the growth substrate as illustrated in Fig. 1D). In particular, when a resin that can form strong contact with the growth substrate is used, impregnation halfway through the CNT layer is effective for making the subsequent removal step be performed easily.

The filler to be used to form a filler layer is not limited to Micromelt 6239 hot-melt filler, and may be any other material provided that it is in a solid state at room temperature, and becomes liquid when heated and returns back into a solid state, exhibiting adhesive force, when cooled thereafter. For example, polyamide-based hot-melt resin, polyester-based hot-melt resin, polyurethane-based resin, modified polyolefin-based hot-melt resin, ethylene copolymer hot-melt resin, modified SBR hot-melt resin, EVA based hot-melt resin, and butyl rubber-based hot-melt resin, etc. may be employed. The melting point of the hot-melt resin is limited its maximum value by the heatproof temperature of the heat dissipating part on which this CNT sheet will be set. There are no other specific limitations for the melting point of the hot-melt resin, as long as it meets the above-mentioned requirement. For instance, it is from about 60°C to 250°C. There are no specific limitations on the thickness of the sheet-like hot-melt resin body. It is preferable to determine the sheet thickness according to the length of the carbon nanotubes 13. A preferable sheet thickness is from 5 µm to 500 µm. The shape of the hot-melt resin is preferably a sheet shape, but there are no specific limitations on its shape. There is no problem to use grain shape or rod shape.

Then, after confirming that spaces among the carbon nanotubes 13 have been filled with the hot-melt filler, the sheet is cooled to solidify the hot-melt resin. Heating temperature and heating time or duration are determined considering the melting point of the hot-melt resin, molten-state viscosity, resin sheet thickness, carbon nanotube length, etc.

As illustrated in Fig. 1E, the carbon nanotubes 13 and filler layer 14 are then peeled from the growth substrate 11 to provide a carbon nanotube sheet 3. Typically, a structure including carbon nanotubes 13 embedded in a filler layer 14 is obtained. The filler layer 14 is solid at room temperature, and it is easy to handle a CNT sheet including a CNT assembly bound by the filler layer 14.

When a CNT sheet is disposed between two objects and the filler layer 14 is heated, the filler layer 14 will be molten and increase the contact area with the objects while decreasing its thickness. When the ends of CNTs come in contact with the objects, the CNTs start to deform elastically, depending on the applied pressure, forming good contact with the objects. The CNTs deform to some extent, but they are oriented generally perpendicularly to the surfaces of the CNT sheet, and this direction is also called as perpendicular.

It is also possible to employ such a structure in which the ends of CNTs are coated with a metal layer having a higher heat conductivity than that of the filler layer. When the ends of CNTs are coated with metal, good contact (electrically and thermally) is established between the CNTs and the metal layer and when the metal coat layer is brought in contact with the objects, good contact can also be established easily.

As illustrated in Fig. 1BX, a layer 15 of metal such as Au is deposited by, for instance, sputtering on a CNT assembly 13 grown on a growth substrate 11. In the case of a CNT assembly 13 with a high number density, the distances between adjacent CNTs are so small that the metal layer 15 will hardly be deposited on the side face of CNTs while only the ends of CNTs are covered with a metal layer 15.

As illustrated in Fig. 1BY, taking out a single CNT, it is in a state that an end of a CNT 13 is covered with a metal layer 15. It becomes easy to create good thermal contact with an object of a heat source or a heat dissipating part.

A substrate as depicted in Fig. 1BX is subjected to potting process as depicted in Figs. 1C-1E. As depicted in Fig. 1F, a CNT sheet 3 in which one ends of CNTs 13 are coated with metal 15, will be obtained.

As depicted in Fig. 1BZ, it is also possible to deposit a metal layer 15 on one end face of the CNT assembly, and thereafter the CNT assembly 13 is peeled off from the growth substrate 11 using, for instance, an adhesion layer 16, and to deposit a layer 17 of metal such as Au on the exposed other end face of the CNT assembly 13 by sputtering etc. A metal layer 15 is formed on one end face of a CNT assembly, and another metal layer 17 is formed on the other end face of the CNT assembly, resulting in CNTs with both ends coated with metal layers.

As depicted in Fig. 1G, a filler layer 14 is potted to the CNT assembly 13 which has the both end faces coated with metal layers, and the CNT assembly 13 with potted filler layer 14 is peeled off from the support to obtain a CNT sheet 3. Each CNT 13 embedded in the filler layer 14 has metal layers 15 and 17 on both ends.

Thus, it is possible to provide a CNT sheet comprising a CNT assembly 13 having no metal layer on both end faces, a CNT sheet comprising a CNT assembly 13 having a metal layer deposited on one end face, and a CNT sheet comprising a CNT assembly 13 having metal layers deposited on both end faces.

Preliminary experiment will be described in which CNT sheets, each having one end face coated with a metal layer and bound with a filler layer, are used. First, since it is important to take out heat from a heat source, the coating of metal layer is disposed on the heat source (CPU) side.

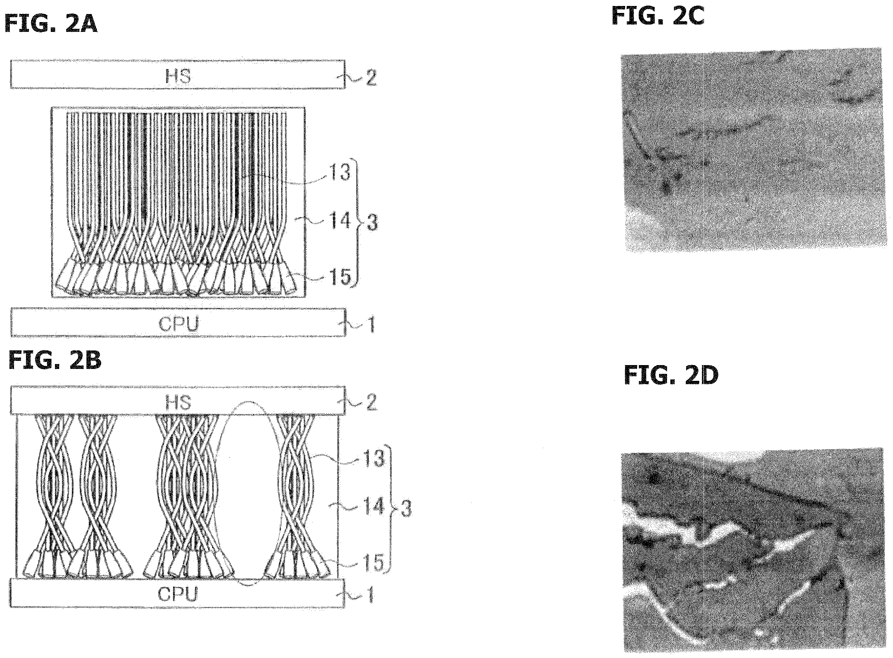

As depicted in Fig. 2A, a CNT sheet 3 comprising a CNT assembly 13 bound by thermoplastic resin 14 is disposed between a heat generator 1, which is a CPU chip, and a heat dissipating part 2, which is a heat spreader, to form a heat dissipator. The thermoplastic resin 14 in the CNT sheet 3 is in a solid phase. To create good thermal contact between the heat generator 1 and the CNTs 13 (more specifically, the metal coating 15 at the end) and between the CNTs 13 and the heat dissipating part 2, it is necessary to heat and melt the thermoplastic resin 14, and apply pressure from both sides of the CNT sheet 3 to bring the both ends of the CNT 13 in physical engagement with the heat generator 1 and the heat dissipating part 2.

As depicted in Fig. 2B, heat and pressure are applied to stacked structure of the heat generator 1 and the heat dissipating part 2. The thermoplastic resin 14 is molten by heating, and the distance between the heat generator 1 and the heat dissipating part 2 is decreased by pressing, making the CNT assembly 13 directly contact with the heat generator 1 and the heat dissipating part 2. The structure was cooled to solidify the thermoplastic resin 14. Observations of the heat dissipating structure after heating, maintaining at an elevated temperature, and cooling, indicated that some CNTs had moved, resulting in generation of CNT-free regions (cracks). When cracks are fine, its influence on the heat dissipation characteristics is also small, but for example the influence on the heat dissipation characteristics cannot be negligible when the width of the cracks exceeds about twice the thickness of the semiconductor substrate. There are possibilities of generating hot spots.

Figs. 2C and 2D are microscope photographs of CNT assemblies generated with cracks. CNT-free regions caused by cracking are clearly seen.

Causes of generating cracks are studied. When a CNT sheet 3 is disposed between a heat generator 1 and a heat dissipating part 2, the CNTs in the CNT assembly are oriented in the direction perpendicular to the surface of the sheet 3. The thickness of the filler layer 14 is larger than the length of the CNTs 13, and accordingly, the both ends of the CNTs cannot come in contact with the heat source 1 and the heat dissipating part 2. As the thermoplastic resin 14 is heated and molten, the heat source 1 and the heat dissipating part 2 approach each other by applied pressure, and the thermoplastic resin 14 will flow outward, at least until the CNT assembly exhibits supporting force. Here, it can be considered that the CNTs 13 also move together with the thermoplastic resin 14.

It can be considered to provide some structure for preventing movement of CNTs, so that the CNTs will not move even when the thermoplastic resin is molten. Concave portion which accommodates the ends of carbon nanotubes and prevents movement thereof may be formed in either one or both of the heat source and the heat spreader.

When the thermoplastic resin, which is used as filler, is molten and a pressure is applied to combine the CPU chip, i.e. heat source, the CNT sheet, and the heat spreader by thermo-compression bonding, the resin moves in the in-plane direction of the heat spreader, but the carbon nanotubes are limited their movement by the concave portion formed in the heat spreader (or the heat source). As a result, it is expected that no crack is generated in the carbon nanotube assembly, preventing local degradation of heat dissipation.

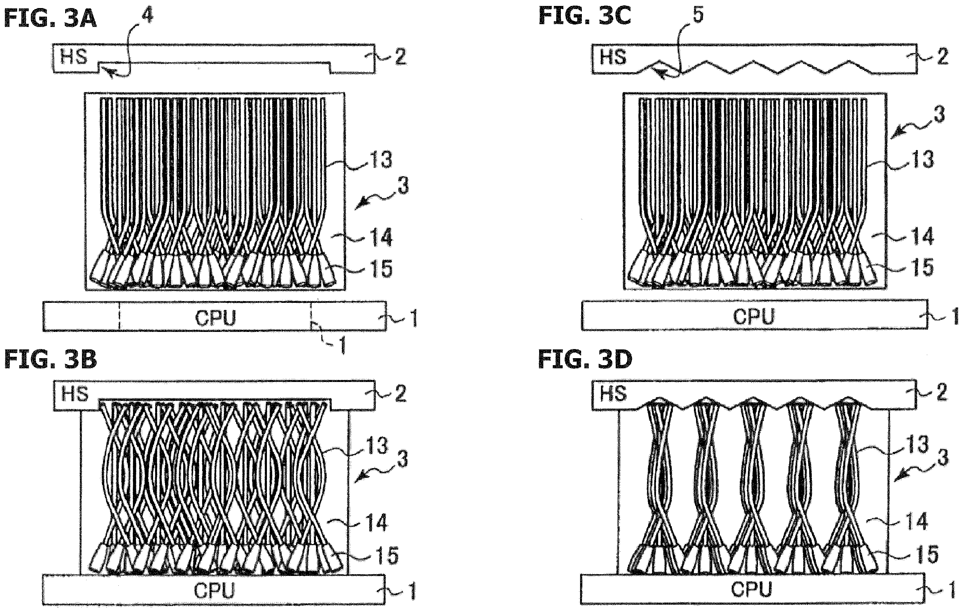

Figs. 3A and 3B illustrate processes for manufacturing the heat dissipating structure according to embodiment 1. As illustrated in Fig. 3A, a CNT sheet 3 in which filler 14 formed of thermoplastic resin is embedded in spaces among a large number of carbon nanotubes 13, is used as a thermal interface material. The CNT sheet 3 is disposed in a region of the CPU chip 1 encompassing a heat generation region. If the heat generation region exists in all the area of the CPU chip 1, a CNT sheet encompassing the entire area of the CPU chip 1 indicated by broken lines, will be used. One ends of the carbon nanotubes 13 are coated with metal 15 having a higher heat conductivity than that of the filler 14. Respective carbon nanotubes 13 are oriented perpendicularly to the surfaces of the sheet. The carbon nanotubes may have either a monolayer or multi-layer structure. The number density is preferably 1x10¹⁰/cm² or more from the viewpoint of heat dissipation efficiency (and electric conductivity according to the cases). The length of carbon nanotubes 13 is determined by the usage of the heat dissipating structure. Although not limitative, the length of the carbon nanotubes is set to, for instance, about 5 µm to 500 µm.

For example, Micromelt 6239 hot-melt filler (melting temperature 135°C to 145°C, molten state viscosity 5.5 Pa-s to 8.5 Pa-s at 225°C) available from Henkel Japan Ltd. may be used as the thermoplastic resin.

A concave portion 4 is provided in that surface of the heat spreader 2 which faces the heat source 1 and is in contact with the CNT sheet 3. The concave portion 4 has a flat bottom, and the concave portion 4 has a rectangular cross section in the thickness direction. The area of the concave portion 4 is designed to accomodate the CNT assembly 13. The depth of the concave portion 4 is designed to be able to prevent movement of the CNTs. To ensure physical contact of the CNTs, the depth of the concave portion 4 should be shorter than the length of the CNTs. The depth of the concave portion 4 may be, for instance, 1 µm to 200 µm, or, for instance, 10 µm to 50 µm. The concave portion 4 is formed by etching or machining. The heat spreader 2 may be of metal, such as copper, in particular, oxygen free copper.

A CNT sheet 3 is disposed on a heat source 1, such as a CPU chip, and a heat spreader 2 is disposed thereabove at a position aligned with the CNT sheet 3. The concave portion 4 faces the CNT sheet 3.

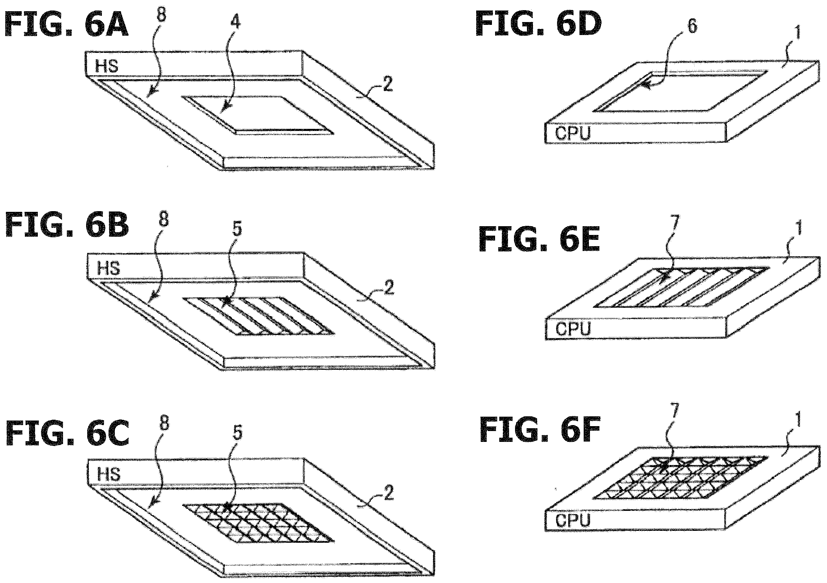

Fig. 6A is a perspective view illustrating an example shape of a heat spreader 2. Two step concave structure is formed in the lower surface of a plate-like heat spreader 2. The larger concave portion 8 is surrounded by a frame-like step and is large enough to encompass the entire CNT sheet 3 and can dam outward flows of the filler 14 of thermoplastic resin if it tends to flow. A concave portion 4 for accomodating the CNT assembly 13 of the CNT sheet 3 is formed at a central portion of the wide concave portion 8. Use of a heat spreader having a larger area than that of the CPU chip 1 may enhance stable handling and heat dissipation characteristics.

As depicted in Fig. 3B, the entire body including a CNT sheet 3 held between a heat spreader 2 and a CPU chip 1 is heated to a temperature at which the thermoplastic resin 14 melts, and a pressure is applied in an appropriate direction so as to bring the CPU chip 1 and the heat spreader 2 closer to each other. For instance, an applied pressure is maintained for 10 minutes to allow carbon nanotubes 13 to appear from the filler layer 14. Those carbon nanotubes 13 which enter the concave portion 4 of the heat spreader 2 will not get outside as their outward movement is restricted by the side walls of the concave portion 4. With the applied pressure maintained, the temperature is lowered to room temperature. This results in a structure including a heat spreader 2 and a CPU chip 1 bonded to each other by the filler layer 14 of a CNT sheet 3. Subsequently, the pressure is removed. The side faces of the concave portion may be inclined due to, for instance, some influence of the manufacturing process. The cross section of the concave portion in this case has precisely a trapezoidal shape, but such a cross section is also called as rectangular as long as its bottom is flat and parallel with the surface.

Described above are cases where a concave portion with a rectangular cross section is formed on the surface of a heat spreader. The concave portion may have other shapes. For instance, it may be such a concave portion formed by digging from the surface to give a cross sectional shape in the thickness direction of the bottom surface having a zigzag shape.

Fig. 3C depicts a case where a concave portion having a cross sectional shape in the thickness direction of the bottom surface having a zigzag shape is formed in the heat spreader 2. For instance, the concave portion in its planar view may include pyramidal or conical cavities or a plurality of grooves distributed in the bottom surface. The CNT sheet 3 and the heat source 1 are as illustrated in Fig. 3A.

Fig. 6B is a perspective view, seen obliquely from below, of a heat spreader 2 having a plurality of parallel grooves and ridges 5 disposed at the bottom. It is similar to the inner concave portion 4 in Fig. 6A, but has grooves and ridges 5. The binding force on the CNT assembly 13 is larger in the direction perpendicular to the grooves and ridges.

Fig. 6C is a perspective view, seen obliquely from below, of a heat spreader 2 having pyramidal cavities or recesses 5 disposed in a matrix (rows and columns) pattern at the bottom. It is similar to the inner concave portion 4 in Fig. 6A, but has pyramidal cavities 5. Cavities distributed two-dimensionally can apply a larger two-dimensional binding force to a CNT assembly 13. Polygons such as triangle, square, and hexagon are known to fill a plane without loss. Accordingly, pyramids such as triangular, quadrangular, and six-side ones are formed to fill a plane without loss.

Fig. 3D depicts a combined structure including a heat spreader 2, CNT sheet 3, and CPU chip 1 after heating and pressing process. CNTs are expected to be distributed stably in deep portions, and CNTs are less likely to exist at crest portions that are surrounded by cavities and are smaller in depth (height). The possibility of hot spot formation increases with an increasing size of the regions where CNTs are less likely to exist. Accordingly, it is preferable that the cycle period of such cavities is at most twice the thickness of the CPU chip.

In embodiment 1, a concave portion was formed on a heat spreader 2 that faced a heat source 1. A concave portion may be formed on a heat source 1 instead. Described below is embodiment 2 in which a concave portion is formed on a heat source.

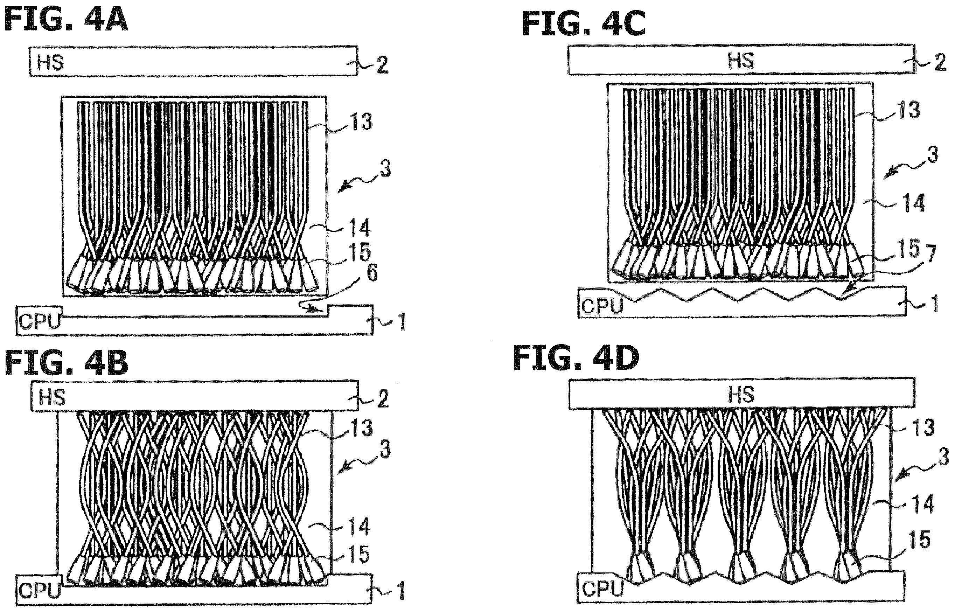

In Figs. 4A and 4B, a concave portion 6 having a rectangular cross section is disposed on a heat source 1. Fig. 4A depicts the relative positions of a heat spreader 2, a CNT sheet 3, and a CPU chip 1 at an initial stage, while Fig. 4B depicts the constitution of a heat dissipating structure after heating and pressing. This case differs from that in Figs. 3A and 3B, as can be seen, in that a concave portion is formed on a CPU chip 1 instead of a heat spreader 2. The rear surface of the semiconductor substrate of a CPU chip is processed, for instance, by etching to produce a concave portion having a rectangular (or trapezoidal) cross section. The position of the CNT assembly 13 on the CPU chip 1 is restricted. Since heat generation occurs in the CPU chip, restriction of the distribution of CNTs that are in contact with the CPU chip may work more directly to ensure heat dissipation.

Fig. 6D is a perspective view of a CPU chip 1 that has a concave portion 6 with a rectangular cross section. It is preferable that the concave portion 6 is designed so as to encompass the heat generation region.

Figs. 4C and 4D depict a case where a concave portion that has a zigzag bottom surface in the cross section is formed on the heat source 1. Fig. 4C depicts the relative positions of a heat spreader 2, a CNT sheet 3, and a CPU chip 1 at an initial stage, while Fig. 4D depicts the constitution of a heat dissipating structure after heating and pressing. A concave portion that has a zigzag bottom shape in the cross section can be formed, for instance, by transfer etching using a resist pattern having a three-dimensional shape (having a thickness distribution).

Fig. 6E is a perspective view, seen obliquely from above, of a heat spreader 2 having a plurality of parallel grooves and ridges 7 disposed in the top surface of an upside-down CPU chip 1. The binding force on the CNT assembly 13 is larger in the direction perpendicular to the grooves and ridges.

Fig. 6F gives a perspective view, seen obliquely from above, of a heat spreader having pyramidal cavities 5 arranged in a matrix pattern in the top surface of an upside-down CPU chip 1. Cavities distributed two-dimensionally can apply a larger two-dimensional binding force to a CNT assembly 13.

Formation of a concave portion is not limited to only one of the heat source and the heat dissipating part. Described below is embodiment 3 in which concave portions are formed on both the heat source and the heat dissipating part.

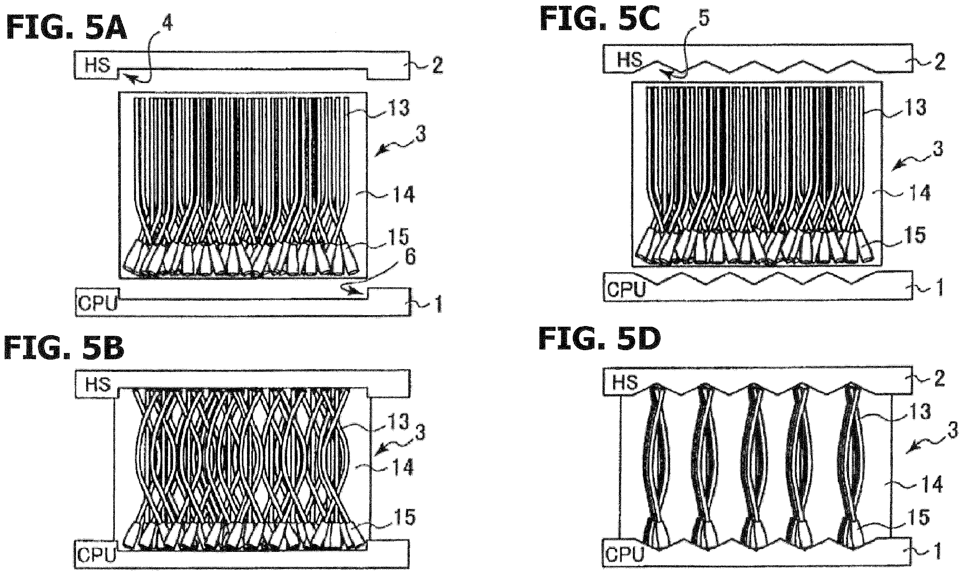

In Figs. 5A and 5B, concave portions having a rectangular cross section are formed on both a CPU chip 1, i.e. heat source, and a heat spreader 2, i.e. heat dissipating part 2. Fig. 5A depicts the relative positions of a heat spreader 2, a CNT sheet 3, and a CPU chip 1 at an initial stage, while Fig. 5B depicts the constitution of a heat dissipating structure after heating and pressing. The distribution of CNTs in the assembly 13 is restricted at both ends, thus ensuring uniform heat dissipation.

In Figs. 5C and 5D, concave portions that have a zigzag bottom shape in the cross section are formed on both a CPU chip 1, i.e. heat source, and a heat spreader 2, i.e. heat dissipating part 2. Fig. 5C depicts the relative positions of a heat spreader 2, a CNT sheet 3, and a CPU chip 1 at an initial stage, while Fig. 5D depicts the constitution of a heat dissipating structure after heating and pressing. The distribution of CNTs in the assembly 13 is restricted at both ends, thus ensuring uniform heat dissipation. Concave portions of similar shapes are formed on a heat spreader 2 and CPU chip 1 in the above case, but it is possible to adopt any combination between a heat spreader 2 having a concave portion as disclosed in either Fig. 3A or 3C and a CPU chip having a concave portion as disclosed in either Fig. 4A or 4C.

Description has been made on the case where one end of a CNT assembly is coated with metal and that the metal coating is disposed on the side of a CPU chip 1. Metal coating is effective in depressing heat resistance, but not a requisite. Either a CNT assembly having no metal coating or a CNT assembly with both ends coated with metal may also be used.

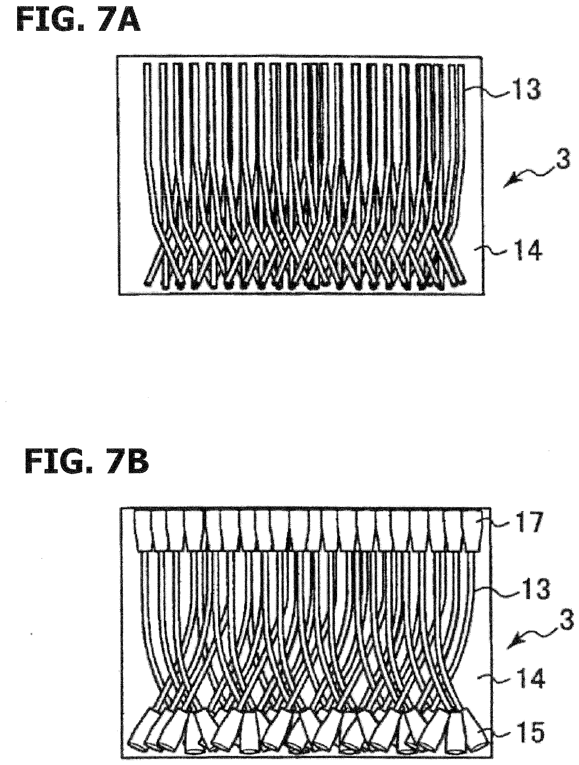

Fig. 7A illustrates a CNT sheet 3 in which a CNT assembly 13 having no metal coating is embedded in a filler 14. A CNT sheet 3 as depicted in Fig. 1E can be used. This is advantageous in that manufacturing steps for the CNT sheet 3 can be simplified.

Fig. 7B illustrates a CNT sheet in which a CNT assembly 13 having both ends coated with metal layers 15 and 17 is embedded in a filler 14. A CNT sheet 3 as depicted in Fig. 1G can be used. This is advantageous in depressing thermal resistance at the ends of CNTs, although manufacturing steps for the CNT sheet may be complicated.

Distribution of CNTs in an assembly can also be restricted to prevent cracking when a CNT sheet as depicted in either Fig. 7A or 7B is used instead of a CNT sheet as depicted in Fig. 3A-3D, 4A-4D, or 5A-5D.

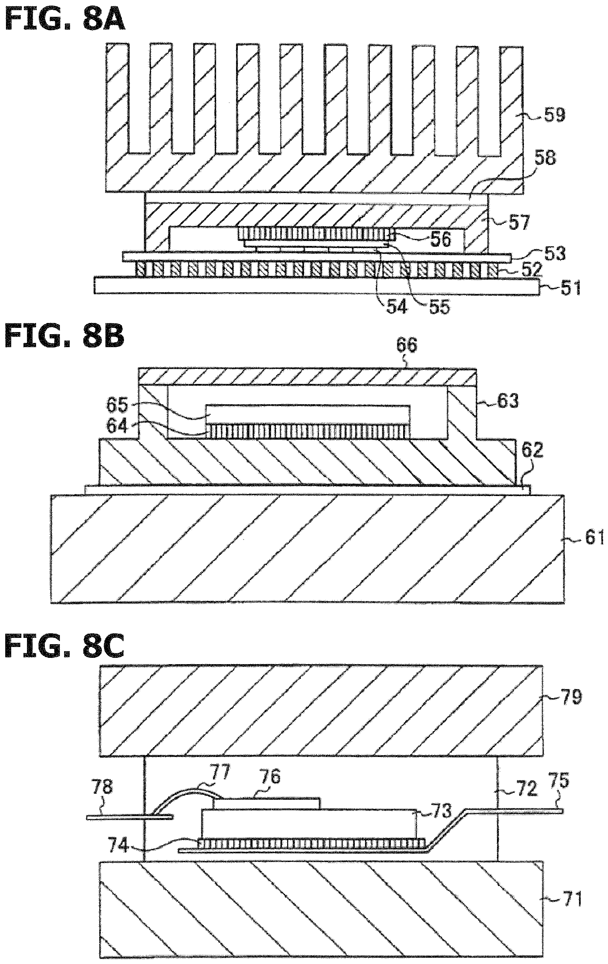

Figs. 8A, 8B, and 8C are schematic cross sections illustrating application examples.

Fig. 8A depicts a high-speed, high-integration semiconductor device package such as central processing units (CPUs) formed on a Si substrate. A buildup substrate 53 is connected via solder bumps 52, to a printed wiring board 51, such as glass epoxy board, and a semiconductor chip 55, such as CPU, is connected by flip chip bonding via solder bumps 54 to the buildup board 53. A heat spreader 57 is disposed on the rear side of the semiconductor chip 55, and a CNT sheet 56 comprising a CNT assembly with both ends coated with metal layers is interposed between the rear surface of the semiconductor chip 55 and the heat spreader 57. The combination of a heat spreader 57, a CNT sheet 56, and a semiconductor chip 55 may be selected from any of the embodiments described above. A radiator fin 59 is connected to the top surface of the heat spreader 57 via an intervening layer 58 of, for instance, silicone grease.

Fig. 8B depicts a high-output amplifier chip package. In facilities such as base stations for cellular telephones, high-frequency, high-output GaN high electron mobility transistors (HEMTs) are used as high power amplifiers. A metal package 63 is disposed on a metal block or a water-cooled heat sink 61 via an intervening layer 58 of, for instance, silicone grease, and a high-output amplifier chip 65 is connected to the bottom surface of the package 63 via a CNT sheet 64. A package cap 66 is placed over the upper opening of the package 63, and sealed.

Fig. 8C depicts an electric power device package. An electric power device 73 embedded in molded resin 72 is disposed on a heat sink 71, and another heat sink 79 is disposed on top of the molded resin that contains the electric power device. The electric power device 73 may be, for instance, a SiC power module that is connected to a lead 75 via a CNT sheet 74. Another lead 78 is connected to the top face of the electric power device via an electrode 76 and a wire 77.

In the constitutions in Fig. 8A, 8B, and 8C, a CNT sheet with both ends coated with metal layers as illustrated in Fig. 1G or 7B, etc. is used as the CNT sheets 56, 64, and 74, for maximizing heat dissipation. When cost is considered, CNTs with one ends coated with metal as depicted in Figs. 1F and 3A, etc. or CNTs having no metal coating at the ends of CNTs as depicted in Figs. 1E and 7A may be used.

The present invention has been described above along the embodiments. The invention is not limited thereto. For instance, CNT sheets may be used not only as a heat-conducting component, but also as an electroconductive component such as earth conductor. The metal used to coat the ends of CNTs is not limited to Au, but may also be selected from Au, Sn, Ag, and Al, according to the situation. When it is used as heat conductor, the material that coats the ends of CNTs may not be metal. It may be permissible to use a semiconductor material or insulation material that has a higher heat conductivity than that of the filler layer. Various modifications, substitutions, alterations, improvements, and combinations will be obvious to those skilled in the art.

## Claims

1. A method for manufacturing a heat dissipating structure comprising:
growing carbon nanotube assembly (13) on a growth substrate;
disposing, on the carbon nanotube assembly (13), a thermoplastic material sheet having a thickness larger than a length of the carbon nanotubes;
heating and melting the thermoplastic material sheet (14) so as to embed the carbon nanotube assembly (13), and thereafter cooling and solidifying the thermoplastic material to form a carbon nanotube sheet (3);
disposing the carbon nanotube sheet (3) between opposing surfaces of a heat source (1) and a heat dissipating part (2), at least one of which opposing surfaces has a concave portion (4, 5, 6, 7), constituting a laminated structure;
heating and pressing the carbon nanotube sheet (3) held between the heat source (1) and the heat dissipating part (2) to melt the thermoplastic material and shorten distance between the heat source (1) and the heat dissipating part (2) so as to bring two end faces of the carbon nanotube assembly (13) in contact with the heat source and the heat dissipating part (2); and
cooling the laminated structure to solidify the thermoplastic material.

2. A method for manufacturing a heat dissipating structure as defined in claim 1, wherein the concave portion (4, 5, 6, 7) is positioned to contain ends of the carbon nanotube assembly (13).

3. A method for manufacturing a heat dissipating structure as defined in either claim 1 or 2, further comprising coating metal to cover an exposed end face of the carbon nanotube assembly (13) after growing of a carbon nanotube assembly (13).

4. A method for manufacturing a heat dissipating structure as defined in claim 3, further comprising:
after coating metal to cover the exposed end face of the carbon nanotube assembly (13), transferring the carbon nanotube assembly (13) onto a support; and
coating metal to cover the exposed other end face of the carbon nanotube assembly (13).

5. A method of manufacturing a heat dissipation structure as defined in any of claims 1-4, wherein the heat dissipating structure is an electronic instrument.

## Patentansprüche

1. Verfahren zum Herstellen einer Wärmeabführungsstruktur, umfassend:
Aufwachsen eines Kohlenstoff-Nanoröhren-Aufbaus (13) auf einem Aufwachs-Substrat;
Anordnen, auf dem Kohlenstoff-Nanoröhren-Aufbau (13), eines Flächenkörpers aus thermoplastischem Material, mit einer Dicke, die größer ist als eine Länge der Kohlenstoff-Nanoröhren;
Erwärmen und Schmelzen des Flächenkörpers (14) aus thermoplastischem Material, so dass der Kohlenstoff-Nanoröhren-Aufbau (13) eingebettet ist, und anschließendes Kühlen und Aushärten des thermoplastischen Materials, um einen Kohlenstoff-Nanoröhren-Flächenkörper (3) zu bilden;
Anordnen des Kohlenstoff-Nanoröhren-Flächenkörpers (3) zwischen gegenüberliegenden Oberflächen einer Wärmequelle (1) und einem Wärmeabführungsteil (2), wobei mindestens eine der gegenüberliegenden Oberflächen einen konkaven Bereich (4, 5, 6, 7) hat, wodurch eine laminierte Struktur ausgebildet wird;
Erwärmen und Pressen des Kohlenstoff-Nanoröhren-Flächenkörpers (3), der zwischen der Wärmequelle (1) und dem Wärmeabführungsteil (2) gehalten wird, um das thermoplastische Material zu schmelzen und den Abstand zwischen der Wärmequelle (1) und dem Wärmeabführungsteil (2) zu verkürzen, so dass zwei Endflächen des Kohlenstoff-Nanoröhren-Aufbaus (13) in Kontakt mit der Wärmequelle und dem Wärmeabführungsteil (2) gebracht werden; und
Kühlen der laminierten Struktur, um das thermoplastische Material auszuhärten.

2. Verfahren zum Herstellen einer Wärmeabführungsstruktur nach Anspruch 1, wobei der konkave Bereich (4, 5, 6, 7) so positioniert ist, dass er Enden des Kohlenstoff-Nanoröhren-Aufbaus (13) enthält.

3. Verfahren zum Herstellen einer Wärmeabführungsstruktur nach Anspruch 1 oder 2, weiter umfassend ein Metallbeschichten, so dass eine freiliegende Endfläche des Kohlenstoff-Nanoröhren-Aufbaus (13) nach einem Aufwachsen eines Kohlenstoff-Nanoröhren-Aufbaus (13) bedeckt ist.

4. Verfahren zum Herstellen einer Wärmeabführungsstruktur nach Anspruch 3, weiter umfassend:
nach dem Metallbeschichten, so dass eine freiliegende Endfläche des Kohlenstoff-Nanoröhren-Aufbaus (13) bedeckt ist, Weitergeben des Kohlenstoff-Nanoröhren-Aufbaus (13) auf eine Stütze; und
Metallbeschichten, so dass die freiliegende andere Endfläche des Kohlenstoff-Nanoröhren-Aufbaus (13) bedeckt ist.

5. Verfahren zum Herstellen einer Wärmeabführungsstruktur nach einem der Ansprüche 1-4, wobei die Wärmeabführungsstruktur ein elektronisches Instrument ist.

## Revendications

1. Procédé de fabrication d'une structure de dissipation de chaleur comprenant :
la croissance d'un assemblage de nanotubes de carbone (13) sur un substrat de croissance ;
la disposition, sur l'assemblage de nanotubes de carbone (13), d'une feuille en matériau thermoplastique ayant une épaisseur supérieure à une longueur des nanotubes de carbone ;
le chauffage et la fusion de la feuille en matériau thermoplastique (14) afin d'enrober l'assemblage de nanotubes de carbone (13), et ensuite le refroidissement et la solidification du matériau thermoplastique pour former une feuille de nanotubes de carbone (3) ;
la disposition de la feuille de nanotubes de carbone (3) entre des surfaces opposées d'une source de chaleur (1) et d'une partie de dissipation de chaleur (2), dont au moins une des surfaces opposées présente une portion concave (4, 5, 6, 7), en constituant une structure stratifiée ;
le chauffage et le pressage de la feuille de nanotubes de carbone (3) maintenue entre la source de chaleur (1) et la partie de dissipation de chaleur (2) pour fondre le matériau thermoplastique et raccourcir la distance entre la source de chaleur (1) et la partie de dissipation de chaleur (2) afin de mettre en contact deux faces d'extrémité de l'assemblage de nanotubes de carbone (13) avec la source de chaleur et la partie de dissipation de chaleur (2) ; et
le refroidissement de la structure stratifiée pour solidifier le matériau thermoplastique.

2. Procédé de fabrication d'une structure de dissipation de chaleur selon la revendication 1, dans lequel la portion concave (4, 5, 6, 7) est positionnée pour contenir les extrémités de l'assemblage de nanotubes de carbone (13).

3. Procédé de fabrication d'une structure de dissipation de chaleur selon la revendication 1 ou 2, comprenant en outre l'application en revêtement d'un métal pour recouvrir une face d'extrémité exposée de l'assemblage de nanotubes de carbone (13) après la croissance d'un assemblage de nanotubes de carbone (13).

4. Procédé de fabrication d'une structure de dissipation de chaleur selon la revendication 3, comprenant en outre :
après l'application en revêtement d'un métal pour recouvrir la face d'extrémité exposée de l'assemblage de nanotubes de carbone (13), le transfert de l'assemblage de nanotubes de carbone (13) sur un support ; et
l'application en revêtement d'un métal pour recouvrir l'autre face d'extrémité exposée de l'assemblage de nanotubes de carbone (13).

5. Procédé de fabrication d'une structure de dissipation de chaleur selon l'une quelconque des revendications 1 à 4, dans lequel la structure de dissipation de chaleur est un instrument électronique.
